# EUROPEAN PATENT APPLICATION

(11) **EP 1 564 573 A1**
(43) Date of publication of application: **17.08.2005**
(21) Application number: 03810591.2
(22) Date of filing: 04.11.2003
(51) Int. Cl.: G02B 6/42, H01S 5/022

(54) **OPTICAL MODULE AND METHOD FOR MANUFACTURING SAME**

(30) Priority: 08.11.2002 JP 2002325604
(71) Applicant: TDK Corporation, Chuo-ku, Tokyo 103-8272 (JP)
(72) Inventor: LO, Adrian Wing Fai, c/o TDK Corporation, Tokyo 103-8272 (JP); HATA, Kenjiro, Tokyo 103-8272 (JP); KINERI, Tohru, Tokyo 103-8272 (JP); HANASHIMA, Naoki, Tokyo 103-8272 (JP)
(74) Representative: HOFFMANN - EITLE
(86) International application number: PCT/JP2003/014076
(87) International publication number: WO 2004/042444

(57) **Abstract**

The present invention relates to an optical module which can be produced by an easy process and at low cost and a method for fabricating the optical module. An optical module 100 includes a die pad 101, a plurality of leads 102, and a first platform 110 and a second platform 120 disposed on the die pad 101. At least an optical fiber 113 is fixed to a first platform body 111 and at least a light emitter 124 adapted for generating optical signals to be transmitted through the optical fiber 113 is mounted on a second platform body 121.

## Description

### BACKGROUND OF THE INVENTION

The present invention relates to an optical module and a method for fabricating the optical module, and more particularly, to an optical module which can be produced by an easy process and at low cost, and a method for fabricating the optical module.

### DESCRIPTION OF THE PRIOR ART

The advent of the Internet allows one to access and manipulate huge quantities of information in real time. Though copper wire, optical fiber, wireless means and the like are used to send and receive information, the optical fiber is especially superior for transmitting huge volumes of information at high speed. Thus, it is expected that the optical fiber will be extended into every household in the future.

However, when connecting terminal devices by optical fibers, it is necessary to provide a so-called optical module between the optical fiber and each terminal device, since terminal devices do not use optical signals but electric signals for information processing. The optical module transforms the optical signals received from the optical fiber into electric signals and provides the electric signals to the terminal device, and further transforms the electric signals received from the terminal device into the optical signals and supplies the optical signals to the optical fiber. Various types of optical modules have been proposed in the art.

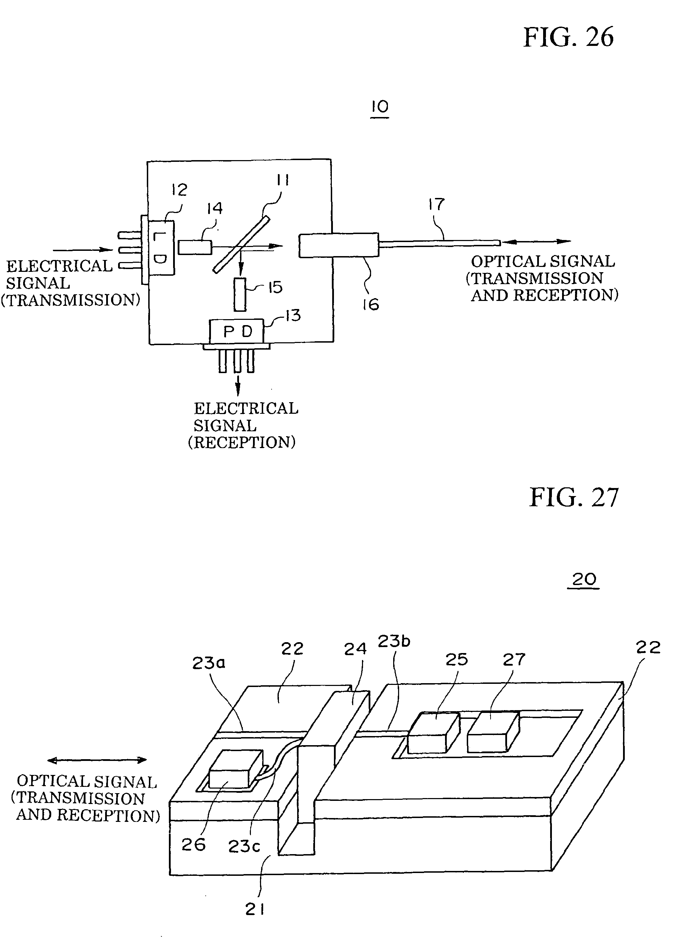

Figure 26 is a schematic view showing the structure of a conventional optical module.

As shown in Fig.26, the optical module 10 can transmit and receive signals in the WDM (wavelength division multiplex) mode. The optical module has a structure wherein a WDM filter 11, a laser diode (LD) 12, a photo diode (PD) 13 and optical lens 14 and 15 are contained in a package 16. The WDM filter 11 is an optical filter that passes light of a predetermined wavelength (for example, about 1.3 µm) used for transmission and reflects light of a predetermined wavelength (for example, about 1.55 µm) used for reception, and it is positioned on the optical path. The laser diode 12 is an element for transforming a supplied electric signal into an optical signal. Light of the predetermined wavelength of, for example, about 1.3 µm emitted from the laser diode 12 is supplied to an optical fiber 17 through the optical lens 14 and the WDM filter 11. Light of the predetermined wavelength of, for example, about 1.55 µm supplied from the optical fiber 17 is reflected by the WDM filter 11, after which it is sent to the photo-diode 13 through the optical lens 15, and is transformed into electric signals. It is therefore possible to transform the optical signals from the optical fiber 17 and supply them to the terminal device, and transform the electric signals from the terminal device and supply them to the optical filter 17. The above example of the light wavelengths assumes that the optical module 10 shown in Fig.26 is installed in a terminal device used in a home. If the optical module 10 is used on the side of the base station, the wavelengths used for transmission and reception are reversed.

However, the optical module 10 of the type shown in Fig.26 requires high accuracy in the positioning the individual elements, and, in some cases, fine tuning by a skilled worker. For this reason, there is a problem that manufacturing efficiency is low, so that the module is not suitable for mass production.

Figure 27 is a schematic view showing the structure of another conventional optical module.

The optical module 20 shown in Fig.27 is a so-called optical waveguide embedded type optical module. The optical module 20 comprises a substrate 21, a cladding layer 22 formed on the substrate 21, core regions 23a-23c formed on a predetermined region of the cladding layer 22, a WDM filter 24 inserted in the slot formed on the substrate 21 and the cladding layer 22, a laser diode 25 provided adjacent to the end of the core region 23b, a photo-diode 26 provided adjacent to the end of core region 23c, and a monitoring photo-diode 27 which monitors the output of the laser diode 25. In the optical module 20 of such type, an optical waveguide constituted by the cladding layer 22 and core region 23a is connected to an optical fiber not shown in the drawing. Accordingly, transmission and reception in the WDM (wavelength division multiplex) mode are performed.

That is, light of the transmission wavelength (for example, about 1.3 µm) emitted from the laser diode 25 propagates through an optical waveguide consisting of the cladding layer 22 and the core region 23b, after which it is supplied to the optical waveguide consisting of the cladding layer 22 and the core region 23a through the WDM filter 24, and enters an optical fiber that is not illustrated. Moreover, light of the reception wavelength (for example, about 1.55 µm) supplied from the optical fiber (not shown) propagates through the optical waveguide consisting of the cladding layer 22 and core region 23a, after which it is supplied to the optical waveguide which consisting of the cladding layer 22 and core region 23c through the WDM filter 24, and enters the photo-diode 26. The output of the laser diode 25 is monitored by the monitoring photo-diode 27, and the output of the laser diode 25 can therefore be optimized.

The optical module 20 of the type described above is smaller than the optical module 10 of the type shown in Fig.26, and it has high productivity because it does not require the fine tuning by a skilled worker. However, there is a problem that it is very expensive and it requires high connection accuracy between the optical fiber and the optical waveguide. Thus, an optical module that can be fabricated by an easy process at low cost is desired.

### SUMMARY OF THE INVENTION

It is therefore an object of the present invention to provide an improved optical module and a method for fabricating the optical module.

Another object of the present invention is to provide an optical module and a method for fabricating the optical module that can realize low cost.

A further object of the present invention is to provide an optical module that can be fabricated by an easy process and a method for fabricating the optical module.

The above objects of the present invention can be accomplished by an optical module comprising a die pad, at least two platform bodies including a first platform body and a second platform body mounted on the die pad, an optical fiber fixed on the first platform body, and a light emitter mounted on the second platform body and adapted for generating optical signals to be transmitted through the optical fiber.

According to the present invention, since at least the first platform body on which the optical fiber is mounted and the second platform body on which the light emitter is mounted can be separately fabricated, it is possible to easily design the platform bodies. Further, in the case of mounting the first platform body and the second platform body separately, since heat generated in the light emitter is not easily transmitted to the first platform body, it is possible to improve the reliability of the optical module and it is possible to control of temperature at each step during fabrication of the optical module. For example, if the first platform body is mounted after first mounting the second platform body and fixing the light emitter and the like, it is possible to fabricate components on the first platform body free from the influence of heat applied when the light emitter and the like are fixed. Furthermore, if the first platform body is mounted after first mounting the second platform body on the die pad and performing a screening test, it is not necessary to perform needless processing on a product in process that has an initial failure, and it is therefore possible to reduce manufacturing cost.

Here, the first platform body and the second platform body may be disposed on the die pad in parallel with each other or the first platform body may be placed on the second platform body. In either case, if the first platform body is mounted after the second platform body was first mounted on the die pad and a screening test was performed, it is not necessary to perform a wasteful process to the product in process which has initial failure.

In a preferred aspect of the present invention, the optical module further comprises a receiving photo-diode mounted on the first platform body and adapted for transforming optical signals received through the optical fiber into electric signals, and a filter provided so that the optical fiber is divided at the position between the receiving photo-diode and the light emitter. The optical module further comprises a ferrule in which the end portion of the optical fiber is inserted.

In a further preferred aspect of the present invention, the optical module further comprises a monitoring photo-diode which is mounted on the second platform body and used for monitoring the luminescence intensity of the light emitter. According to this aspect of the present invention, it is not only possible to optimize the luminescence intensity of the light emitter but also perform the screening test easily.

In a further preferred aspect of the present invention, the optical module further comprises an encapsulation member which covers at least part of the first platform body and the second platform body and part of the die pad. According to this preferred aspect of the present invention, since the at least two platform bodies mounted on the die pad are integrally covered by the encapsulating member, the optical module is very easy to handle. Further, since, differently from the conventional optical module, the optical module does not require fine tuning by a skilled worker, it has high fabrication efficiency. Moreover, the optical module can be realized at relatively low cost, which is not possible with the optical module including a conventional optical waveguide.

In a further preferred aspect of the present invention, the optical module further comprises silicone gel which covers at least part of the optical fiber, the receiving photo-diode, the light emitter or the filter. According to this preferred aspect of the present invention, it is possible to protect the optical fiber, the receiving photo-diode, the light emitter and/or the filter efficiently.

In a further preferred aspect of the present invention, the optical module further comprises at least one IC which receive the output signals from the receiving photo-diode and process the output signals and/or drive the light emitter. In this case, the at least one IC may be mounted on the first platform body or the second platform body, and may also be mounted on the die pad.

In a further preferred aspect of the present invention, the optical module further comprises a plurality of leads at least some of which are covered by an encapsulation member. According to this preferred aspect of the present invention, since the optical module can be mounted on a printed circuit board similarly to a conventional semiconductor device, the optical module can be easily handled. In this case, the plurality of leads may be drawn out from a package body consisting of the encapsulation member or may be terminated at a mounting surface of the package body. If the plurality of leads are provided so as to be terminated at the mounting surface of the package body, since the mounting area of the optical module on a printed circuit board can be reduced, it is possible to produce a much smaller end product.

In a further preferred aspect of the present invention, the die pad is located at a side opposite to a mounting surface of a package body with respect to the platform bodies. According to this preferred aspect of the present invention, since the die pad located on the upper surface side of the package body serves as a heat sink, it is possible to obtain a very high heat radiating property. It is therefore possible to realize miniaturization of the end product and improved reliability.

Here, the die pad may be provided on a printed circuit board.

The above objects of the present invention can be also accomplished by a method for fabricating an optical module for transmitting and receiving optical signals comprising a step of mounting on a die pad a second platform body including at least a light emitter which generates optical signals to be transmitted, a step of mounting on the die pad or the second platform body a first platform body including at least optical fibers, a receiving photo-diode that performs photoelectric conversion of an optical signal received through the optical fibers and a filter that separates the optical signal received from the optical signal to be transmitted, and a step of encapsulating the second platform body and the first platform body with an encapsulation member so that end portions of the optical fibers opposite to the light emitter are exposed.

According to the present invention, since the LE platform body including the light emitter and the PD platform body including the receiving photo-diode and the like are mounted on the die pad and integrally encapsulated with the encapsulation member, the thus fabricated optical module can be easily handled. Moreover, since, differently from the conventional optical module, the optical module does not require fine tuning by a skilled worker, it has high fabrication efficiency and it is possible to realize relatively low cost, which is not possible with the optical module including the conventional optical waveguide.

In a preferred aspect of the present invention, the method for fabricating an optical module further comprises a step of mounting the second platform body on the die pad, performing a screening test and mounting the first platform body on the die pad. According to this preferred aspect of the present invention, it is not necessary to perform needless processing on a product in process that has an initial failure.

In a further preferred aspect of the present invention, the method for fabricating an optical module further comprises a step of applying silicon gel to cover at least part of the optical fiber, the receiving photo-diode, the light emitter or the filter. According to this preferred aspect of the present invention, it is possible to effectively protect the optical fiber, the receiving photo-diode, the light emitter and/or the filter.

### BRIEF DESCRIPTION OF THE DRAWINGS

Figure 1 is a plan view schematically showing the structure of an optical module 100 which is one preferred embodiment of the present invention.
Figure 2 is a side view schematically showing the structure of a main portion of an optical module 100.
Figure 3 is a perspective view schematically showing the structure of a first platform (PD platform) 110.
Figure 4 is a perspective view schematically showing the structure of a second platform (LE platform) 120.
Figure 5 (a) is a schematic top plan view showing the external appearance of an optical module 100 and Figure 5 (b) is a cross-sectional view taken along a line A-A in Figure 5 (a).
Figure 6 is a schematic top plan view showing an optical module 100 mounted on a printed circuit board and the like.
Figure 7 is a diagram showing a step in the fabrication of an optical module 100 (preparing of lead frame 105).
Figure 8 is a diagram showing a step in the fabrication of an optical module 100 (pre-mold).
Figure 9 is a diagram showing a step in the fabrication of an optical module 100 (cutting predetermined portions 105b, 105c and 105d of the lead frame 105).
Figure 10 is a diagram showing a step in the fabrication of an optical module 100 (mounting LE platform 120).

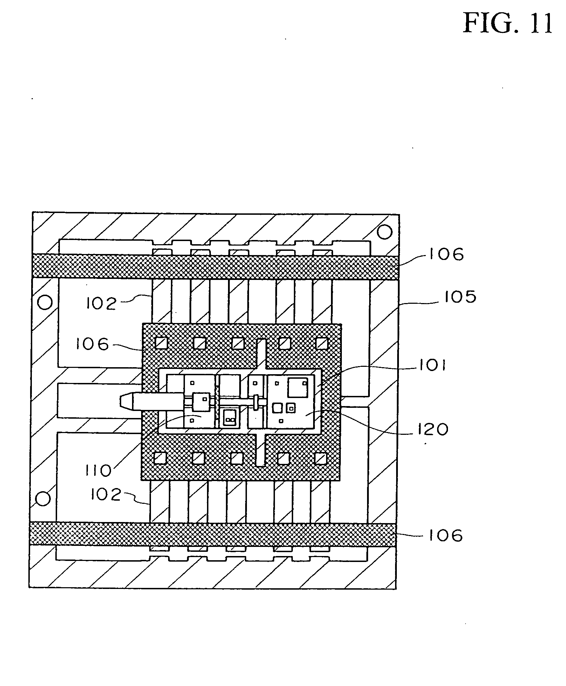

Figure 11 is a diagram showing a step in the fabrication of an optical module 100 (mounting PD platform 110).
Figure 12 is a plan view schematically showing the structure of a main portion of an optical module 200 which is another preferred embodiment of the present invention.
Figure 13 is a side view schematically showing the structure of a main portion of an optical module 200.
Figure 14 is a plan view schematically showing the structure of a main portion of an optical module 300 which is a further preferred embodiment of the present invention.
Figure 15 is a side view schematically showing the structure of a main portion of an optical module 300.
Figure 16 is a plan view schematically showing the structure of a main portion of an optical module 400 which is a still further preferred embodiment of the present invention.
Figure 17 is a side view schematically showing the structure of a main portion of an optical module 400.
Figure 18 (a) is a schematic top plan view showing an external appearance of an optical module 500 which is a yet further preferred embodiment of the present invention and Figure 18 (b) is a cross-sectional view taken along a line B-B in Figure 18 (a).
Figure 19 (a) is a schematic top plan view showing the external appearance of an optical module 600 which is a yet further preferred embodiment of the present invention and Figure 19 (b) is a cross-sectional view taken along a line C-C in Figure 19 (a).
Figure 20 is an external view showing one preferred embodiment of an optical connector including an optical module according to the present invention.
Figure 21 is an external view showing another preferred embodiment of an optical connector including an optical module according to the present invention.
Figure 22 is a top plan view showing an optical module 800 according to an embodiment in which the PD platform and the LE platform are mounted on a printed circuit board.
Figure 23 is a bottom view schematically showing the structure of an optical module 800.
Figure 24 is a top plan view showing the resin encapsulated optical module 800.
Figure 25 is a side view showing the resin encapsulated optical module 800.
Figure 26 a schematic view showing the structure of a conventional optical module.
Figure 27 is a schematic view showing the structure of another conventional optical module.

### DESCRIPTION OF THE PREFERED EMBODIMENT

Preferred embodiments of the present invention will now be explained with reference to the drawings.

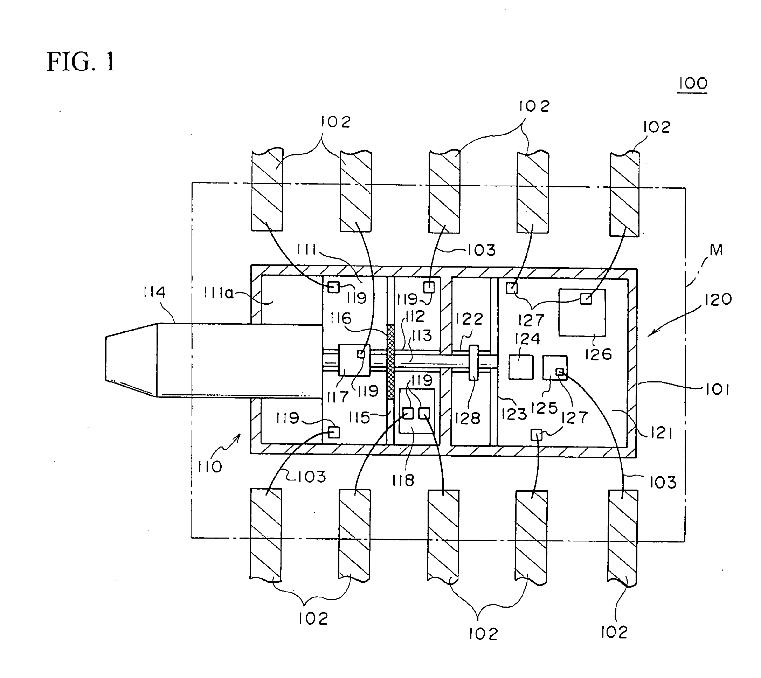

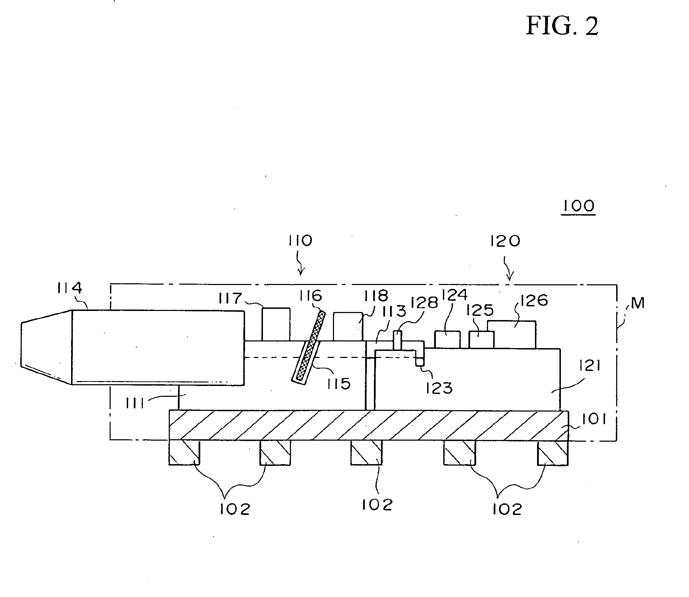

Figure 1 is a plan view schematically showing the structure of an optical module 100 which is one preferred embodiment of the present invention and Figure 2 is a side view schematically showing the structure of a main portion of the optical module 100. Although the optical module 100 of this embodiment is ultimately encapsulated and its main portions covered by a resin, as will be explained further below, Figure 1 shows the optical module 100 without the encapsulating resin. The region indicated by M in Figures 1 and 2 is the region to be ultimately encapsulated.

As shown in Figures 1 and 2, the optical module 100 according to this embodiment has a die pad 101, a plurality of leads 102, a first platform 110 and a second platform 120 which are mounted on the die pad 101.

The die pad 101 and the leads 102 are portions formed by cutting or etching a lead frame and are formed of metal. The kind of metal used for forming each of the die pad 101 and the leads 102 is not particularly limited but it is preferable to form both the die pad 101 and the leads 102 of an alloy having excellent electrical conductivity, thermal conductivity, mechanical strength and the like normally used for forming a lead frame, such as an alloy containing copper as a primary component or an alloy containing iron as a primary component such as 42-alloy (A42). The thickness of the die pad 101 and the leads 102 is set to be as thin as possible so as to ensure the required mechanical strength. The actual thickness thereof is not particularly limited but it is preferable to form both the die pad 101 and the leads 102 so as to have a thickness of 0.1 mm to 0.25 mm. The area of the die pad 101 is determined in accordance with the bottom surface area of the first platform 110 and the second platform 120.

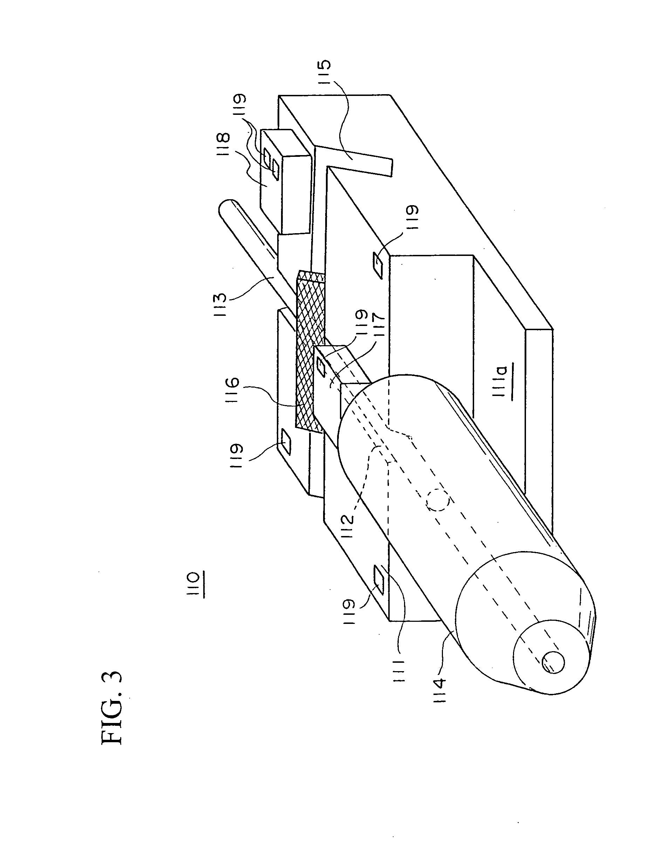

The first platform 110 is a platform on which various parts for transforming optical signals supplied from the optical fiber into electric signals are mounted. A perspective view of the first platform 110 is shown in Figure 3.

As shown in Figures 1 to 3, the first platform 110 comprises a first platform body 111 made of silicon or the like, a groove 112 formed on the upper surface of the first platform body 111, an optical fiber 113 accommodated in the groove 112, a ferrule 114 provided at the end portion of the optical fiber 113, a slit 115 formed on the upper surface of the first platform body 111 so as to cross the groove 112, a WDM filter 116 inserted in the slit 115, a receiving photo-diode 117 and a receiving IC 118 mounted on the upper surface of the first platform body 111, and bonding pads 119 formed on the upper surface of the first platform body 111, the upper surfaces of the receiving photo-diode 117, the receiving IC 118 and the like. In this embodiment and a following embodiment, the first platform 110 is sometimes referred to as a PD (photo-diode) platform and the first platform body is sometimes referred to as a PD platform body.

The PD platform body 111 is made of a silicon block or the like. A step 111a is cut at the portion on the PD platform body 111 where the ferrule 114 is mounted, and the ferrule 114 is supported by the step 111a. Such a step 111a can be formed by chemical etching or mechanical dicing. Although not illustrated, an insulation film coating, such as an oxide film or a nitride film, is also formed on the upper surface of the PD platform body 111. The pad electrodes, wiring and the like connecting with some of the bonding pads 119, the receiving photo-diode 117 and the like are provided on the insulation film coating.

The groove 112 is a guidance groove for holding the optical fiber 113. The width and depth thereof are set large enough to accommodate the optical fiber 113. The groove 112 can also be formed by chemical etching or mechanical dicing. The optical fiber 113 accommodated in the grooves 112 is fixed by an adhesive agent (not illustrated).

As known widely, an optical fiber is a fiber-shaped optical waveguide which consists of a core and a cladding surrounding the core, and light propagation can be attained by utilizing the difference of these refractive indexes. The end surface of the optical fiber 113 is made flat and smooth by polishing.

As known widely, a ferrule has cylinder shape which can hold an optical fiber. One end portion of the optical fiber 113 terminates inside of the ferrule 114. By inserting another optical fiber whose end portion is polished into the ferrule 114, it is possible to accomplish optical coupling between the two optical fibers.

The slit 115 is formed on the upper surface of the PD platform body 111 so as to cross the groove 112. The width and depth thereof are set according to the size of the WDM filter 116 inserted into it. If the width of the slit 115 is wider than necessary, diffraction loss will increase. Thus, the width of the slit 115 is set only slightly larger than the thickness of the WDM filter 116. The slit 115 is provided at a predetermined angle so that the light propagating through the optical fiber 113 from the side of the ferrule 114 reflects at the WDM filter 116 and advances in a direction above the upper surface of the PD platform body 111. The angle of the slit 115 is not particularly limited but it is preferably set at an angle of about 30 degree to a plane perpendicular to the upper surface of the PD platform body 111. The slit 115 can also be formed by the chemical etching or the mechanical dicing. However, it is preferably formed by mechanical dicing because, differently from the step 111a and the groove 112, it needs to be formed at the predetermined angle while simultaneously cutting the optical fiber 113.

The WDM filter 116 is an optical filter which transmits light of the transmission wavelength (for example, about 1.3 µm) and reflects light of the reception wavelength (for example, about 1.55 µm). Since the WDM filter 116 is inserted into the slit 115 formed at the above-mentioned predetermined angle, it reflects light of the reception wavelength propagating through the optical fiber 113 from the side of the ferrule 114 upwardly of the PD platform body 111, while it transmits light of the transmission wavelength propagating through the optical fiber 113 from the side of the LE platform 120 toward the side of the ferrule 114. In addition, the slit 115 into which the WDM filter 116 is inserted is filled with an optical resin (not illustrated), thus the WDM filter 116 is securely fixed by the resin in the slit 115.

The receiving photo-diode 117 is an element that detects light of the reception wavelength reflected by the WDM filter 116 at its bottom surface and transforms the optical signals into electrical signals. The receiving photo-diode 117 is mounted so as to straddle the groove 112 at the position where a reflective light from the WDM filter 116 can be received.

The receiving IC 118 is a device for at least receiving and processing the output signals of the receiving photo-diode 117. Transfer of the data between the receiving IC 118 and the receiving photo-diode 117 is performed through the wiring pattern (not shown) formed on the upper surface of the PD platform body 111, and transfer of the data between the receiving IC 118 and a terminal device (not shown) is performed through the bonding pads 119 or the leads 102. moreover, as shown in Figures 1 to 3, if a bonding pad 119 is formed on the photo-diode 117, the transfer of some of the data or the supply of power between the receiving photo-diode 117 and the terminal device (not illustrated) can be performed directly. Although only a single receiving IC 118 is mounted on the PD platform 110 for each transceiver unit in this embodiment, the number of receiving ICs is not particularly limited and two or more ICs may be mounted per transceiver unit. Moreover, it is also possible to omit the receiving IC 118 if the signal from the receiving photo-diode 117 is processed by another IC not mounted on the PD platform 110.

The first platform (PD platform) 110 is configured as explained above.

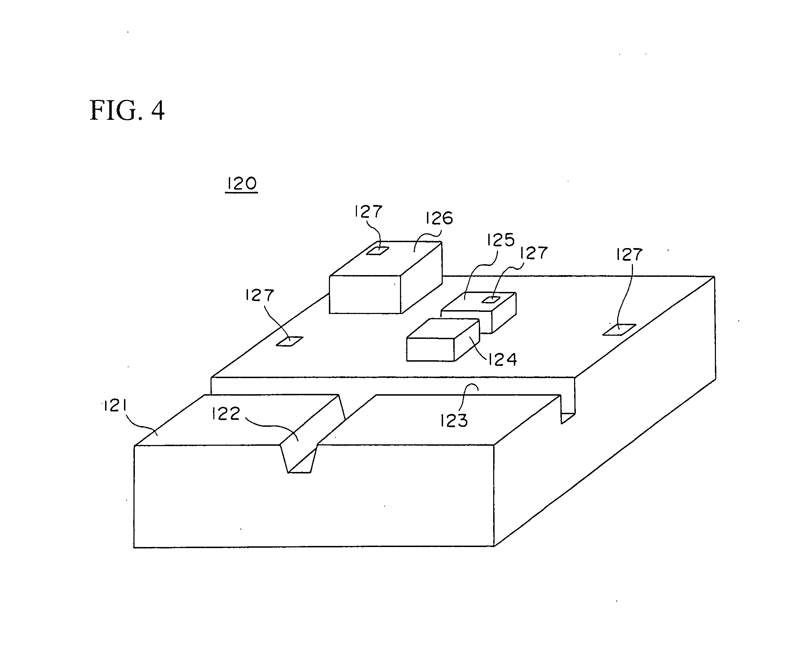

The second platform 120 is a platform on which various components for transforming electric signals supplied from the terminal device into optical signals and transmitting them through the optical fiber 113 are mounted. A perspective view of the second platform 120 is shown in Figure 4. Figure 4 shows the state before mounting the second platform 120 on the die pad 101, and the optical fiber 113 and the like are not illustrated.

As shown in Figures 1, 2 and 4, the second platform 120 comprises an second platform body 121 made of silicon or the like, a V groove 122 formed on the upper surface of the second platform body 121, a trench 123 formed on the upper surface of the second platform body 121 so as to cross the end portion of the V grove 122, and a light emitter 124, a monitoring photo-diode 125, a transmitting IC 126 mounted on the upper surface of the LE platform body 121, bonding pads 127 formed on the upper surface of the second platform body 121, the upper surfaces of the monitoring photo-diode 125, the transmitting IC 126 and the like. Here, in this embodiment and a following embodiment, the second platform 120 is sometimes referred to as an LE (light emitting) platform and the second platform body is sometimes referred to as an LE platform body.

The LE platform body 121 is made of a silicon block or the like, as well as the PD platform body 111. Although not illustrated, an insulation film coating, such as an oxide film or a nitride film, is also formed on the upper surface of the LE platform body 121. Some of the bonding pads 127, the pad electrodes, or the wiring connected with some of the bonding pads 127, the light emitter 124 and the like are provided on the insulation film coating.

The V groove 122 is a guidance groove for correctly aligning the optical fiber 113 mounted therealong, and the shape thereof is defined so that the end portion of the optical fiber 113 faces the light projecting surface of the light emitter 124 correctly. The V groove 122 can also be formed by chemical etching or mechanical dicing. Chemical etching is more preferable because it is necessary to position the optical fiber 113 correctly.

The trench 123 is provided so as to make the end portion of the V groove 122 a vertical plane. This is done because the end portion the V groove 122 may become taper-like when the V groove 122 is formed by chemical etching and in such a case, it becomes difficult to orient the optical fiber 113 and the light projecting surfaces of the light emitter 124 in the correct opposing relationship. In order to correctly oppose the end portion of the optical fiber 113 and the light projecting surfaces of the light emitter 124, the end portion of the V groove 122 needs to fall in a vertical plane, and in order to realize this, the trench 123 is formed. The trench 123 can also be formed by chemical etching or mechanical dicing.

The light emitter 124 is an element for generating the light projected into the optical fiber 113. It can be a laser diode (LD) or a light emitting diode (LED). The light emitter 124 has two opposing light projecting surfaces. One light projecting surface is located on the side of the V groove 122, and the other light projecting surface is located on the side of the monitoring photo-diode 125. Therefore, part of the light from the light emitter 124 is supplied to the optical fiber 113 installed in the V groove 122, and the remainder is supplied to the monitoring photo-diode 125.

The monitoring photo-diode 125 is used to receive the light from the other light projecting surface of light emitter 124 and to monitor its intensity. The output of the monitoring photo-diode 125 is supplied to the transmitting IC 126, which optimizes the luminescence intensity of light emitter 124.

The transmitting IC 126 is a device for receiving at least the signal transmitted from a terminal device and the output signal of the monitoring photo-diode 125, processing these signals, and driving the light emitter 124. Transfer of the data between the transmitting IC 126 and light emitter 124 or the transmitting IC 126 and the monitoring photo-diode 125 is performed through the wiring pattern (not shown) provided on the upper surface of LE platform body 121. Transfer of the data between the transmitting IC 126 and the terminal device (not illustrated) is performed through the bonding pads 127 and the leads 102, which are not illustrated. Moreover, as shown in Figures 1 and 4, if bonding pads 127 are formed on the monitoring photo-diodes 125 and the like, the transfer of some of the data between the terminal device (not illustrated) and the monitoring photo-diode 125 and supply of power can be performed directly. In addition, although a single transmitting IC 126 is mounted on the LE platform 120 for each transceiver unit in this embodiment, the number of the transmitting ICs is not limited to one but can be two or more. Moreover, it is also possible to omit the transmitting IC 126 when the light emitter 124 is driven by another IC which is not mounted on the LE platform 120.

The optical module 100 of this embodiment is completed by mounting the PD platform 110 and the LE platform 120 of the foregoing structure in order on the die pad 101, connecting the bonding pads 119, 127 and the leads 102 by the bonding wires, and encapsulating the area M with resin.

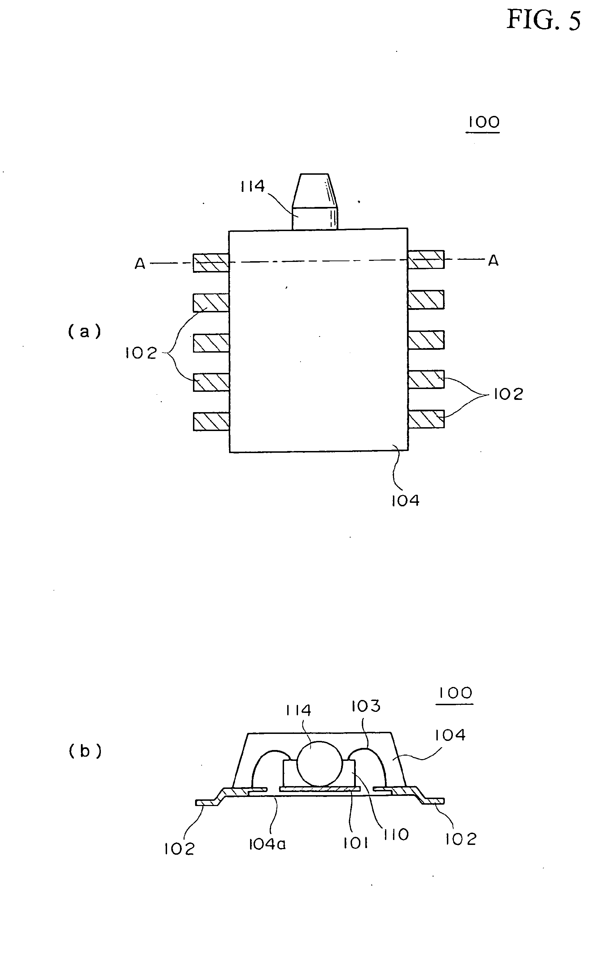

Figure 5 (a) is a schematic top plan view showing an external appearance of the optical module 100 and Figure 5 (b) is a cross-sectional view taken along a line A-A in Figure 5 (a).

As shown in Figure 5 (a) and Figure 5 (b), the optical module 100 according to this embodiment comprises a package body 104 made of resin and having an approximately rectangular parallelepiped shape, a plurality of leads 102 drawn out from both side faces of the package body 104 and bent in the direction of mounting side 104a of the package body 104, and two ferrules 114 projecting from a side face different from the side faces the leads 102 are drawn out from. In other words, the appearance of the optical module 100 is similar to an ordinary packaged semiconductor device. For this reason, it can be mounted on a printed circuit board similarly to general semiconductor devices, making it is very easy to handle.

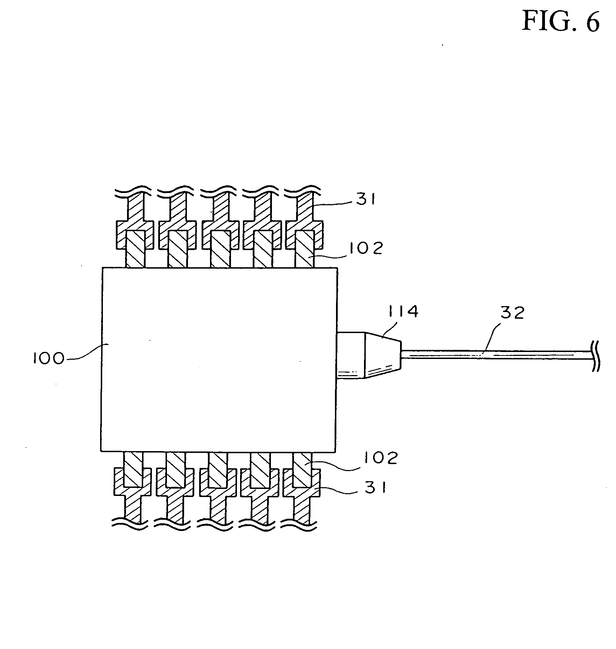

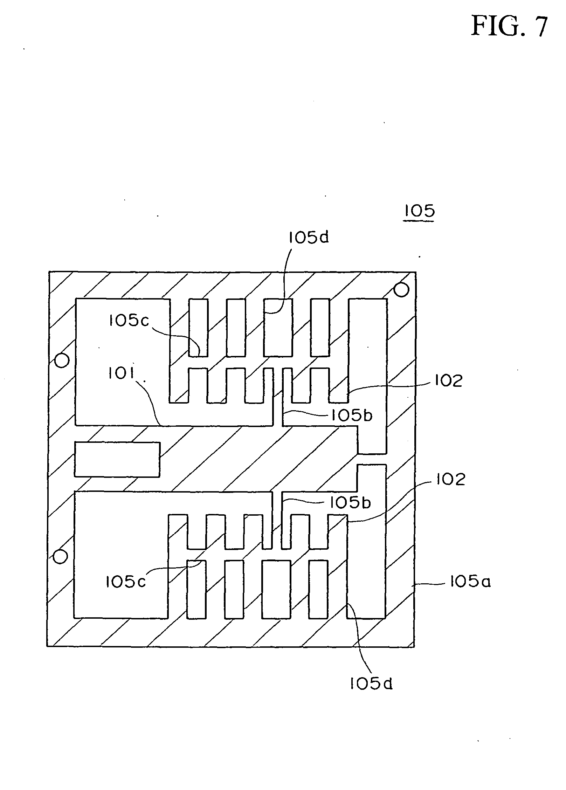

Figure 6 is a schematic top plan view showing the optical module 100 mounted on a printed circuit board or the like. As shown in Figure 7, when an optical module 100 according to this embodiment is mounted on a printed circuit board or the like, an electrode pattern 31 provided on the surface of the printed circuit board and the leads 102 of the optical module 100 are connected electrically and mechanically with solder or the like, and another optical fiber 32 is fixed by insertion into the ferrule 114. Thus, the optical module 100 can communicate electrically with a specified terminal device through the electrode pattern 31 and communicate optically with another terminal through the optical fiber 32.

Next, a method for fabricating the optical module 100 according to this embodiment will be explained in detail.

The method for fabricating the PD platform 110 will be explained first. In fabricating the PD platform 110, a block member of silicon or the like to serve as the PD platform body 111 is first prepared, an insulation film coating, such as an oxide film or a nitride film, is formed on the upper surface of the block member, electrodes such as the bonding pads 119 and wiring patterns are formed on the insulation film coating, and a step 111a and grooves 112 are formed on the PD platform body 111 by chemical etching or mechanical dicing. Alternatively, the step 111a and the groove 112 may be formed before forming the insulation film coating, electrodes and the like. Furthermore, the electrodes may be formed after forming the step 111a, the groove 112 and the insulation film coating.

On the other hand, an optical fiber 113 whose end portions are both polished is prepared and one end portion thereof is inserted into and fixed in the ferrule 114. The optical fiber 113 having the ferrule 114 at the one end portion thereof is accommodated in the groove 112 and fixed in the groove 112 with an adhesive agent. At this time, as shown in Figure 3, the optical fiber 113 needs to project only a predetermined length from the PD platform body 111.

Next, the slit 115 is formed by chemical etching or mechanical dicing, preferably by mechanical dicing, and the WDM filter 116 is inserted into the slit 115. And the excess space of the slit 115 is filled with optical resin, thereby fixing the WDM filter 116 in the slit 115.

Then, the receiving photo-diode 117 and the receiving IC 118 are mounted on the electrode pattern formed on the PD platform body 111. Thus, the PD platform 110 has been fabricated.

Next, a method for fabricating the LE platform 120 will be explained. In fabricating the LE platform 120, a block member of silicon or the like to serve as the LE platform body 121 is prepared in a manner similar to the fabrication of the PD platform 110. An insulation film coating, such as an oxide film or a nitride film, is formed on the upper surface of the block member, and electrodes such as the bonding pads 127 and wiring patterns are formed on the insulation film coating. Then, the V groove 122 is formed on the LE platform body 121 by chemical etching or mechanical dicing, preferably chemical etching, and the trench 123 is formed on the LE platform body 121 by chemical etching or mechanical dicing, preferably mechanical dicing. The V groove 122 and the trench 123 may be formed before forming the insulation film coating, electrode and the like. Furthermore, the electrodes may be formed after forming the V groove 122 and trench 123, the insulation film coating. However, it is necessary to form the trench 123 after forming at least the V groove 122.

Next, the light-emitter 124, the monitoring photo-diode 125 and the IC for transmission 126 are mounted on the electrode pattern formed on the LE platform body 121. This completes the LE platform 120.

Next, a method for mounting the PD platform 110 and the LE platform 120 on the die pad 101 will be explained.

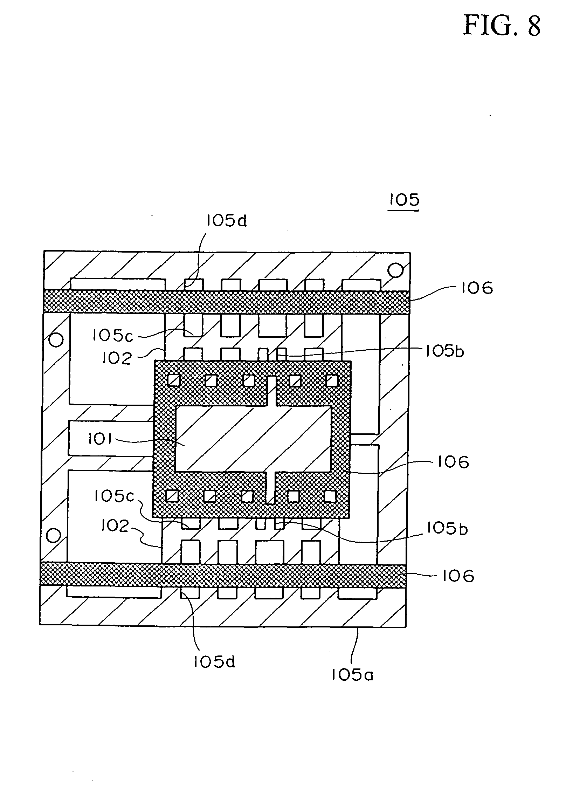

First, as shown in Figure 7, a lead frame 105 including the die pad 101 and the leads 102 is fabricated. Such a lead frame 105 can be produced by punch machining or etching of a metal plate. Next, as shown in Figure 8, the die pad 101 and one tip end portion of leads 102 are connected with resin 106, such as PPS (polyphenylene sulfide), and further, each lead 102 and an outer frame 105a of the lead frame 105 are connected (pre-molding).

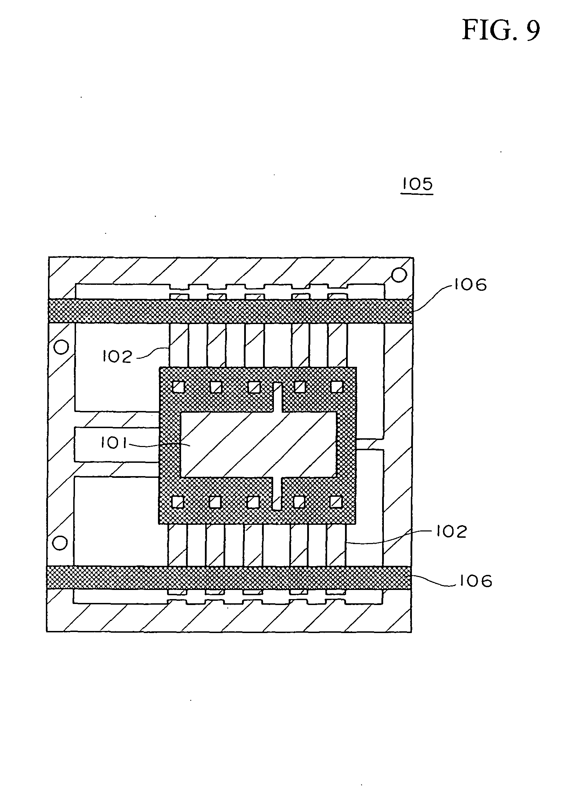

After such pre-molding, the portions 105b connecting the die pad 101 and leads 102, as shown in Figure 9, the portions 105c interconnecting the leads 102, and the portions 105d connecting the leads 102 and the outer frame 105a of the lead frame 105 are cut. Thereby the die pad 101, the leads 102 and the outer frame of the lead frame 105 are electrically separated from one another. In this state, since the die pad 101 and leads 102, and further the leads 102 and the outer lead 105a of the lead frame 105, are connected, they are kept in an integrated state.

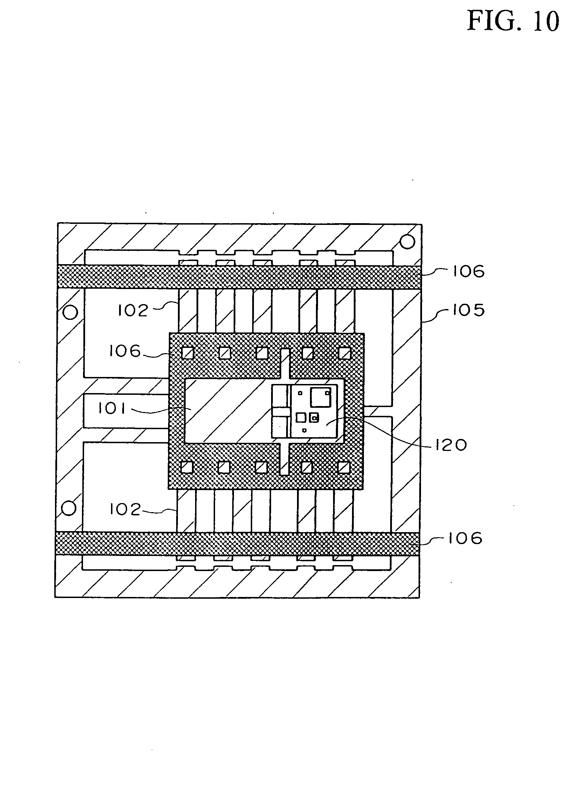

Next, as shown in Figure 10, the LE platform 120 is mounted on a predetermined portion of the die pad 101, and the bonding pads 127 and the predetermined leads 102 are connected electrically by the bonding wires 103. Next, in this state, an electric signal is transmitted to the LE platform 120 through the leads 102 connected to the bonding wires 103, and a screening test is performed. The screening test is a test for discovering initial failure of the light emitter 124 by maintaining application of a few hundred mA of driving current to the emitters 124 for a few hours. By monitoring the intensity of the signal detected with the monitoring photo-diode 125, it is possible to discover any initial failure of the light emitter 124. Subsequent fabricating processes are performed only on products in process that pass the screening test, and no subsequent process is performed on products in process in which initial failure of the light emitter 124 was discovered in the screening test. It is therefore possible to eliminate pointless processing.

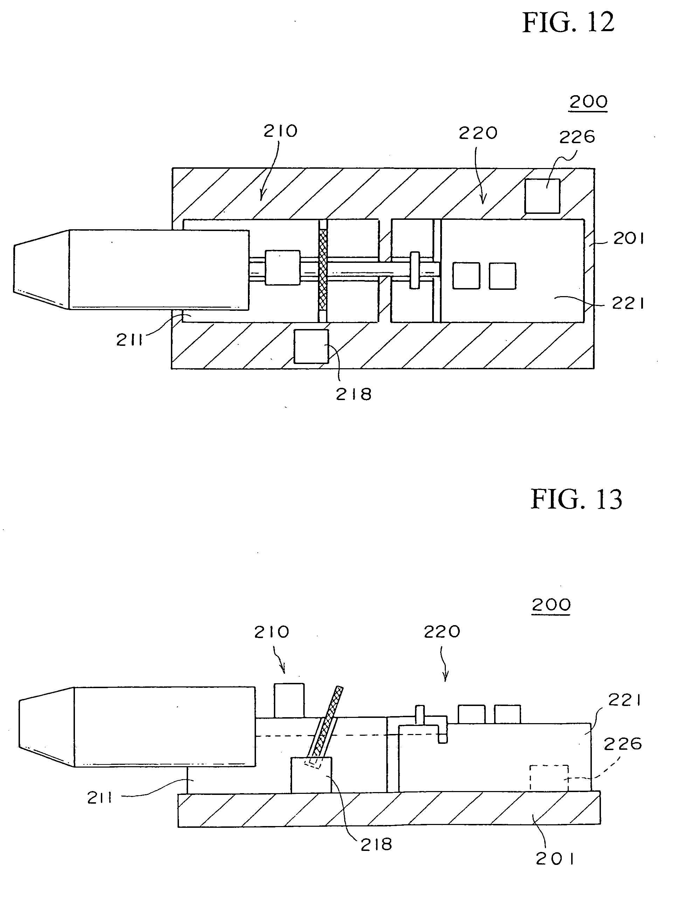

When the screening test is passed, the PD platform 110 is mounted on a predetermined area of the die pad 101 as shown in Figure 12, and the optical fiber 113 is arranged along the V groove 122, by which the end portion of the optical fiber 113 is made to face to the light emitting surface of the light emitter 124 correctly. Next, an adhesive agent 128 (see Figures 1 and 2) is applied to the optical fiber 113 installed in the V groove 122 and hardened, by which the optical fiber 113 is fixed in the V groove 122. The material of the adhesive agent 128 is not particularly limited but a thermosetting resin or ultraviolet-light curable resin can be used. Moreover, the optical fiber 113 may be fixed by lids, such as of silicon or quartz, instead of the adhesive agent 128.

Next, bonding pads on each platform and predetermined leads 102 are connected electrically with bonding wires 103, after which silicone gel (not illustrated) is applied onto all optical functional elements, such as the photo-diodes for reception 117, the light emitter 124 and the like. Such silicone gel mainly serves to ensure propagation of the light signals between the light emitter 124 and optical fiber 113 and as a buffer for protecting the optical functional elements, such as the light emitter 124 and the like, from mechanical stress from outside. The mechanical stress is absorbed by the silicone gel.

Further, the area M shown in Figures 1 and 2 is molded with resin and the leads 102 are cut, by which the optical module 100 is completed.

As described above, since the PD platform 110 and the LE platform 120 are mounted on a single die pad 101 and these are encapsulated integrally by resin, the optical module 100 of this embodiment can be handled very easily. Further, differently from the conventional optical module shown in Figure 26, the optical module 100 does not require fine tuning by a skilled worker and is therefore high in fabricating efficiency. It is therefore possible to realize relatively low cost as compared with the optical module 20 including the conventional optical waveguide shown in Figure 27.

Further, if the LE platform 120 is first mounted on the die pad 101 and the PD platform 110 is then mounted, the parts on the PD platform 110 will not be affected by the heat imparted when mounting the light emitter 124 and the like on the LE platform body 121. Accordingly, it becomes easy to control temperature at each process in the fabrication.

Furthermore, in the fabrication of the optical module 100 of this embodiment, the PD platform 110 is mounted after mounting the LE platform 120 on the die pad 101 and a screening test is then carried out. As a result, it is not necessary to perform needless processing on a product in process that has an initial failure, and is therefore possible to reduce manufacturing cost.

In the above described optical module 100, although the receiving IC 118 is mounted on the PD platform body 111 and the transmitting IC 126 is mounted on the LE platform body 121, the IC may be mounted on the die pad 101 in the present invention. Next, an embodiment in which the receiving IC 118 and the transmitting IC 126 are mounted on the die pad 101 will be explained.

Figure 12 is a plan view schematically showing the structure of a main portion of an optical module 200 which is another preferred embodiment of the present invention and Figure 13 is a side view schematically showing the structure of the optical module 200. The optical module 200 of this embodiment is finally encapsulated and main portions are covered with resin. Figures 12 and 13 therefore show the state where the resin is removed from the optical module 200. Further, the leads and the boding wires are also omitted from Figures 12 and 13.

As shown in Figures 12 and 13, the optical module 200 according to this embodiment has a PD platform 210 and an LE platform 220 which are mounted on a die pad 201, similarly to the optical module 100 according to the above embodiment. However, it is different from the optical module 100 according to the above embodiment in the point that the receiving IC 218 and the transmitting IC 226 are mounted on the die pad 201. In other aspects of the configuration of the optical module 200 is the same as that of the optical module 100.

The optical module 200 according to this embodiment offers the same advantages as the optical module 100 according to the above embodiment. Further, since the receiving IC 218 and the transmitting IC 226 are not mounted on a PD platform body 211 and an LE platform body 221 but are mounted on the die pad 201, it is possible to make the PD platform body 211 and then LE platform body 221 small. As a result, it is possible to reduce the manufacturing cost as well as the cost of materials, because a large number of platform bodies 211, 221 can be produced at one time by cutting a silicon wafer processed in a predetermined manner or the like into many pieces.

In this connection, in the optical module 200 according to this embodiment, although the two ICs are mounted on the die pad 201, the number of ICs mounted on the die pad may be only one or three or more. Further, a predetermined IC may be mounted on the die pad 201 and the other ICs may be mounted on the PD platform body 211 and/or the LE platform body 221.

In the above described optical module 100 or 200, both the PD platform 110 or 210 and the LE platform 120 or 220 are mounted on the die pad 101 or 201. However, in the present invention, the PD platform 110 or 120 may be mounted on the LE platform 120 or 220 instead of the die pad 101 or 201. Next, an embodiment in which a PD platform is mounted on an LE platform will be explained.

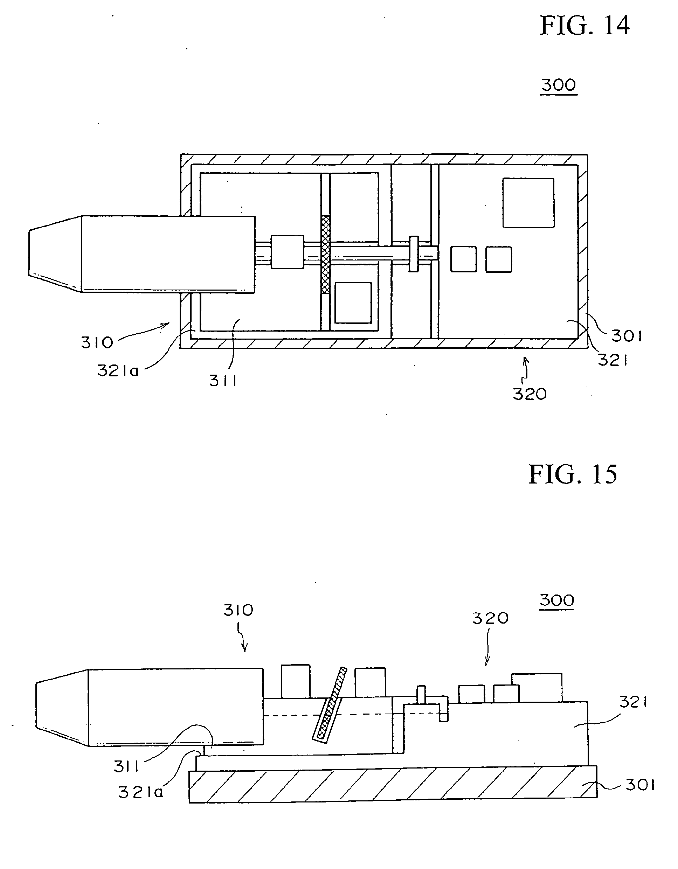

Figure 14 is a plan view schematically showing the structure of an optical module 300 which is a further preferred embodiment of the present invention and Figure 15 is a side view schematically showing the structure of the optical module 300. The optical module 300 of this embodiment is finally encapsulated and main portions are covered with resin. Figures 14 and 15 therefore show the state where the resin is removed from the optical module 300. Further, the leads and the boding wires are also omitted from Figures 14 and 15.

As shown in Figures 14 and 15, the optical module 300 according to this embodiment has a PD platform 310 and an LE platform 320 which are mounted on a die pad 301, similarly to the optical module 100 according to the above embodiment. However, it is different from the optical module 100 according to the above embodiment in the point that the PD platform 310 is not mounted on a die pad 301 but is mounted on a mounting region 321a provided on the LE platform body 321 of the LE platform 320. In other aspects of the configuration of the optical module 200 is the same as that of the optical module 100.

The optical module 200 according to this embodiment offers the same advantages as the optical module 100 according to the above embodiment. Further, since the PD platform 310 and the LE platform 320 are substantially integrated, there is an advantage that the positional relationship between the light emitter 124 and the optical fiber 113 cannot change easily even if the shape of the die pad 301 changes slightly owing to heat stress.

Moreover, although the optical module 100, 200 or 300 has the capability to receive optical signal and the capability to transmit optical signals, in the present invention, it is sufficient for the optical module to have only the capability to transmit optical signals.

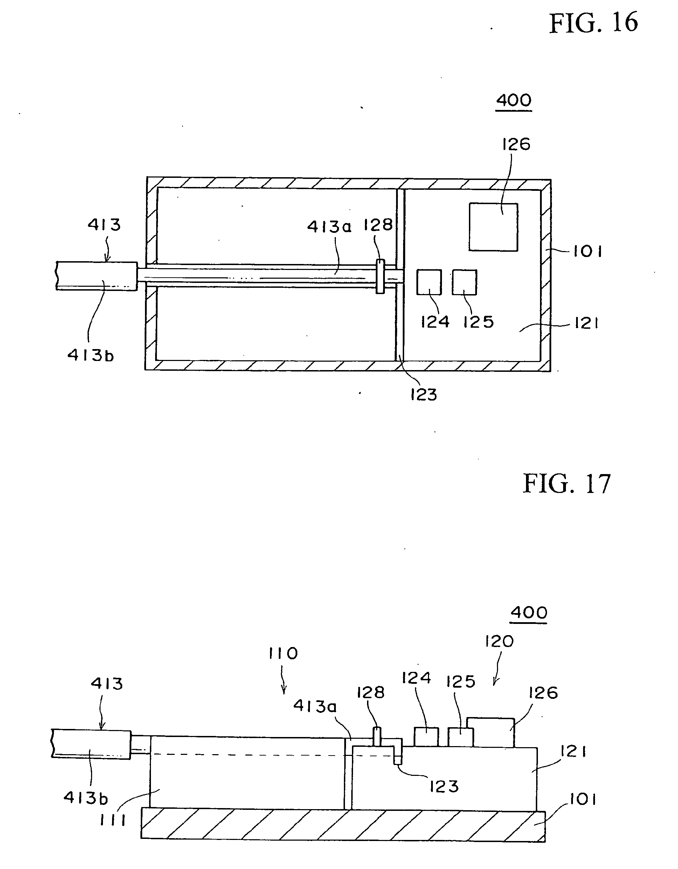

Figure 16 is a plan view schematically showing the structure of an optical module 400 which is a still further preferred embodiment of the present invention and Figure 17 is a side view schematically showing the structure of the optical module 400. The optical module 400 of this embodiment is ultimately encapsulated and its main portions covered with resin. Figures 16 and 17 show the optical module 400 without the encapsulating resin. Further, the leads and the boding wires are also omitted from Figures 16 and 17.

As shown in Figures 16 and 17, the optical module 400 according to this embodiment is different from the optical module according to the above embodiments only in that it has only the capability to transmit optical signals. More specifically, the first platform body 111 is not mounted with a WDM filter 116, receiving photo-diode 117, receiving IC 118 or the the like and does not include the slit 115 for insertion of a WDM filter 116. Further, in this embodiment, no optical fiber accommodated in a ferrule 114 is mounted on the first platform body 111 and an optical fiber wire 413a is directly mounted on the first platform body 111. In other aspects of the configuration of the optical module 400 is the same as that of the optical module 100. The optical fiber is generally provided with a coating and a coating 413b formed on the portion of the optical fiber 413 projecting from the first platform body 111 remains without being removed but the coating 413b formed on the portion of the optical fiber 413 mounted on the first platform body 111 is removed. Thus, the optical fiber wire 413a is fixed in a V groove 412 formed on the first platform body 111.

The optical module 400 according to this embodiment offers the same advantages as the optical module 100, 200 or 300 according to the above embodiments even in the case where it does not have the capability to transmit optical signals. More specifically, it is possible to prevent the heat imparted when mounting the light emitters 124 and the like on the second platform body from affecting the first platform and it is further possible to mount the first platform after mounting the second platform on the die pad and performing the screening test. Moreover, according to this embodiment, the optical module 400 does not have the capability to transmit optical signals and the number of components is proportionally fewer, whereby it is unnecessary to accommodate the tip end portion of the optical fiber in the ferrule. As a result, it is possible to simplify the process for manufacturing the optical module 400 and reduce the manufacturing cost of the optical module 400.

Furthermore, the package of the optical module in the present invention is not particularly limited to the package shown in Figure 5 and some other package may be adopted. Next, an embodiment in which another package is adopted will be explained.

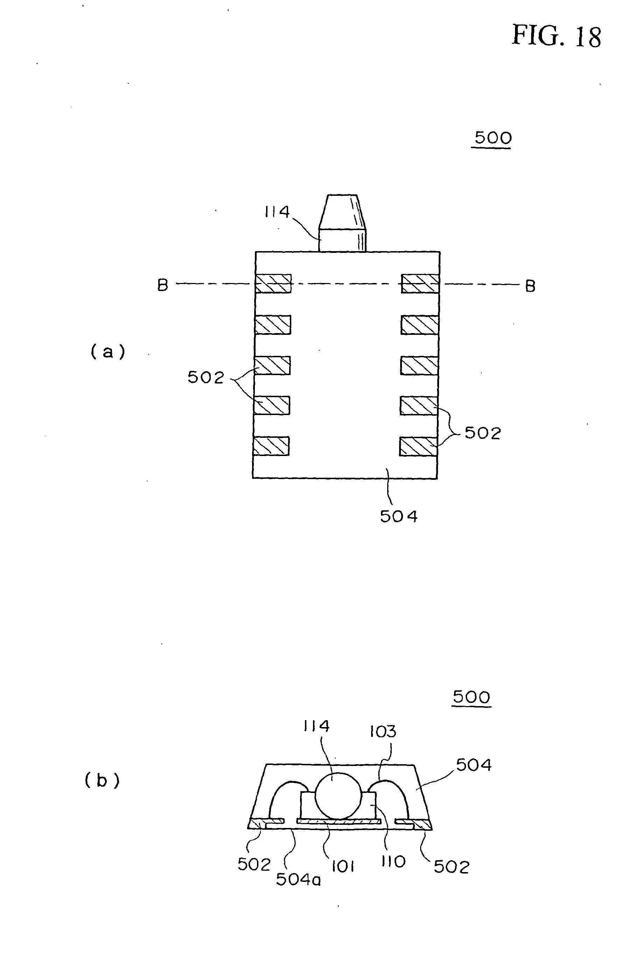

Figure 18 (a) is a schematic top plan view showing an external appearance of an optical module 500 which is a yet further preferred embodiment of the present invention and Figure 18 (b) is a cross-sectional view taken along a line B-B in Figure 18 (a). The optical module 500 according to this embodiment has the same configuration as that of the optical module 100 of the above embodiment except that a package having a different shape is used. In other words, the optical module 500 has such a configuration that the PD platform 110 and the LE platform 120 are mounted on the die pad 101.

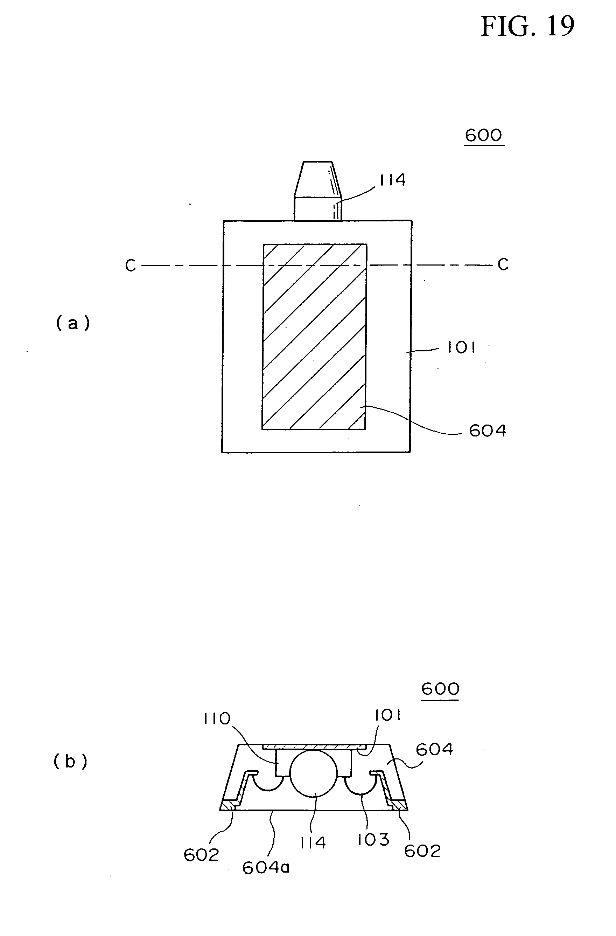

As shown in Figure 18 (a) and Figure 18 (b), like the optical module 100, the optical module 500 according to the present embodiment comprises a package body 504 made of resin and having an approximately rectangular parallelepiped shape. However, its leads 502 do not project but terminate at a mounting surface 504a of the package body 504. According to this embodiment, since the mounting area of the optical module 500 on a printed circuit board or the like is smaller than that of the optical module 100, it is possible to produce a much smaller end product. Figure 19 (a) is a schematic top plan view showing an external appearance of an optical module 600 which is a yet further preferred embodiment of the present invention and Figure 19 (b) is a cross-sectional view taken along a line C-C in Figure 19 (a). The optical module 600 according to this embodiment has the same configuration as that of the optical module 100 of the above embodiment except that a package having a different shape is used. In other words, the optical module 600 has such a configuration that the PD platform 110 and the LE platform 120 are mounted on the die pad 101.

As shown in Figure 19 (a) and Figure 19 (b), like the optical model 500, the optical module 600 according to the present embodiment comprises a package body 604 made of resin and having an approximately rectangular parallelepiped shape and leads 602 which terminate at its mounting surface 604a. The reverse face of the die pad 101 is exposed at the upper surface of the package body 604, i.e., the surface on the opposite side from the mounting surface 604a of the package body 604. In other words, in this embodiment, a portion including the die pad 101, the PD platform 110 and the LE platform 120 is oriented upside down relative to the same portion of the optical module 600 and is encapsulated so that the bottom face of the die pad 101 is exposed at the upper surface of the package body 604.

According to this embodiment, similarly to the optical module 500 of the above embodiment, it is possible not only to reduce the mounting area on a printed circuit board to smaller than that of the optical module 100, but also to obtain a very high heat radiating property because the die pad 101 exposed at the upper surface of the package body 604 serves as a heat sink. It is therefore possible to realize miniaturization of the end product and improved reliability. In this embodiment, although the bottom surface of the die pad 101 is directly exposed, a heat sink can be separately provided on the bottom surface of the die pad 101 and heat radiation be conducted through the exposed heat sink.

Next, an optical connector incorporating an optical module according to the present invention will be explained.

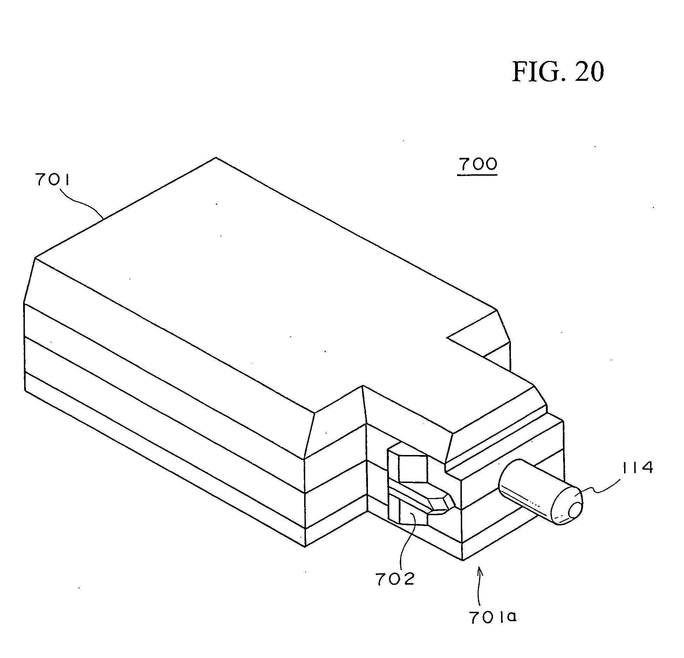

Figure 20 is an external view showing one preferred embodiment of an optical connector including an optical module according to the present invention. As shown in Figure 20, the optical connector 700 comprises an optical module (hidden from view) and a case 701 accommodating the optical module, and the case 701 has a connecting portion 701a of narrow width. The ferrules 114 project from at the connecting portion 701a. Further, locking portions 702 are formed on both side surfaces of the connecting portion 701a. It is therefore possible to couple the optical connector optically and mechanically by inserting the connecting portion 701a of the optical connector 700 shown in Figure 20 into the mating connecting portion of another optical connector (not shown) and fixing the two connectors with the locking portions 702.

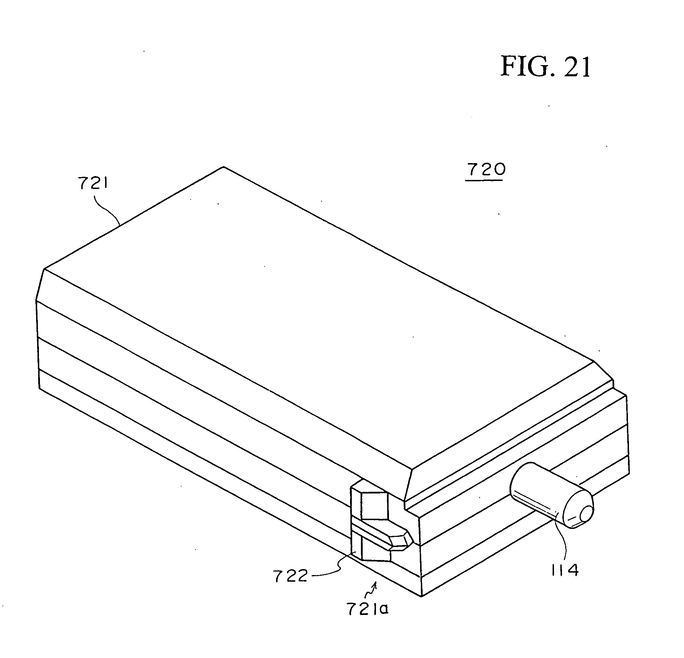

Figure 21 is an external view showing another preferred embodiment of an optical connector including an optical module according to the present invention. As shown in Figure 21, the optical connector 720 is different from the optical connector 700 shown in Figure 20 in that its case 721 has no portion of narrow width and the part from which the ferrule 114 projects itself comprises a connecting portion 721a. It is therefore possible to couple two optical connectors optically and mechanically by inserting the connecting portion 721a of the optical connector 720 shown in Figure 21 into a mating connecting portion of another optical connector (not shown) and fixing the connectors with the locking portions 722.

In the present invention, the member on which the PD platform and the LE platform are mounted is not limited to the die pad of the lead frame insofar as it is possible to support the PD platform and the LE platform mechanically and to achieve the desired heat radiating property.

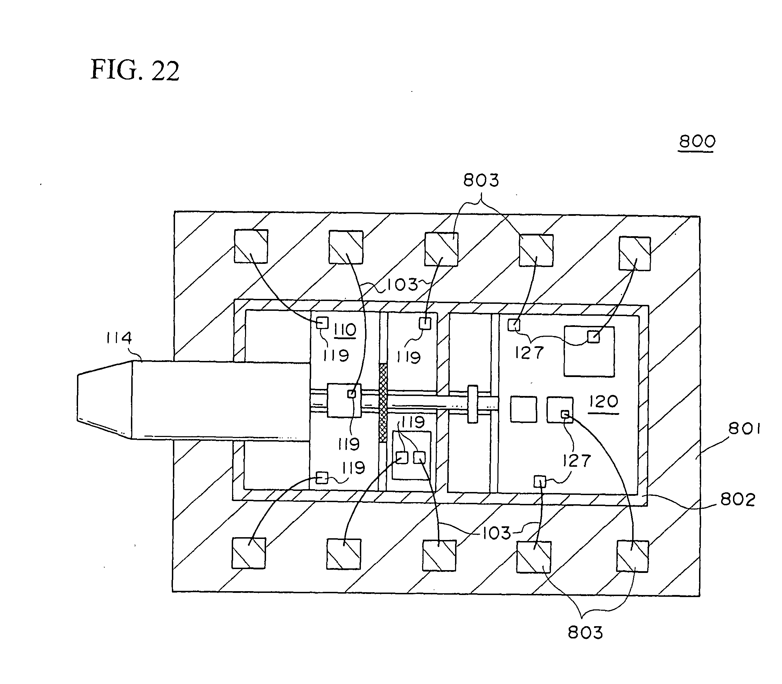

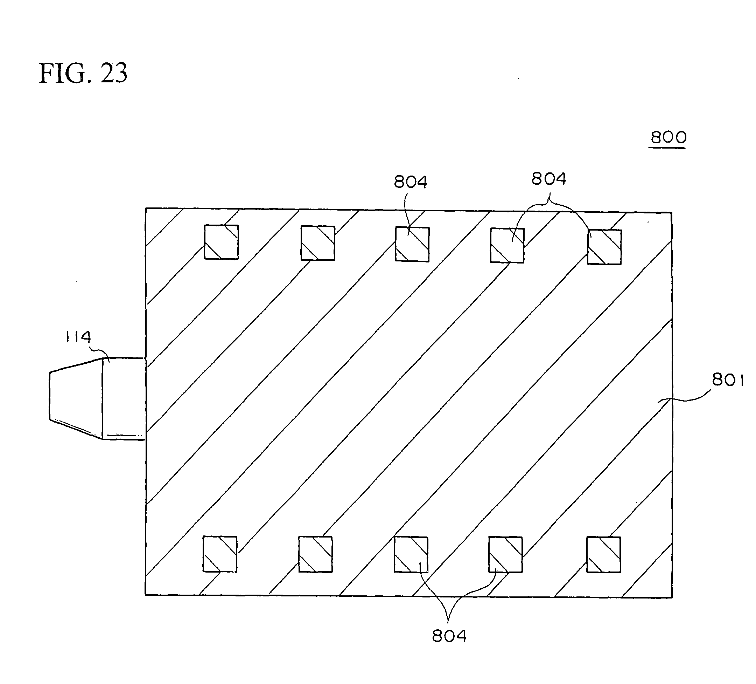

Figure 22 is a top plan view showing an optical module 800 according to an embodiment in which the PD platform and the LE platform are mounted on a printed circuit board and Figure 23 is the bottom view thereof. The optical module 800 of this embodiment is finally encapsulated and main portions are be covered by resin. Figures 22 and 23 therefore show the optical module 800 in the state with the resin removed.

As shown in Figure 22, the optical module 800 according to this embodiment has a PD platform 110 and an LE platform 120 mounted on a die pad 802 formed on a printed circuit board 801. Bonding pads 119 and 127 are connected to bonding pads 803 formed on the printed circuit board 801 through bonding wires 103. The material of the printed circuit board 801 is not particularly limited but it is preferably resin or ceramic. The die pad 802 and the bonding pads 803 can be formed by metalizing the surface of the printed circuit board 801. As shown in Figure 22, it is possible to form the ferrule 114 so as to project from the printed circuit board 801.

As shown in Figure 23, external electrodes 804 connected to corresponding ones of the bonding pads 803 are formed on the bottom surface of the printed circuit 801. When the optical module 100 is mounted on another printed circuit board, electrical connection is established through the external electrodes 804. The bonding pads 803 and the outer electrodes 804 are connected through internal wiring (hidden from view). The external electrodes 804 can be formed by metalizing the bottom surface of the printed circuit.

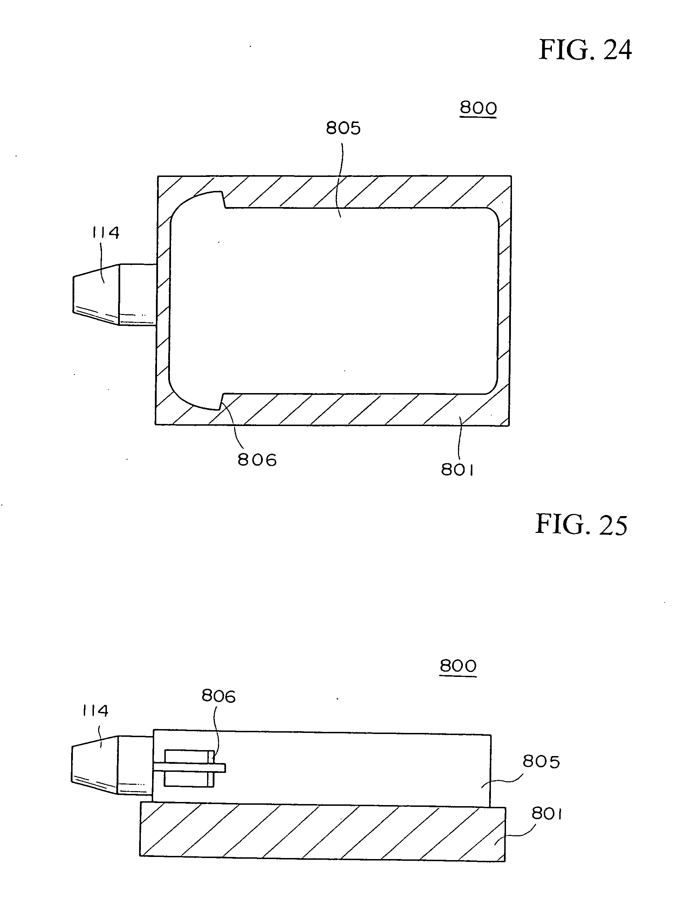

Figure 24 is a top plan view showing the resin encapsulated optical module 800 and Figure 25 is the side view thereof. As shown in Figures 24 and 25, the surfaces of the die pad 801 and the bonding pads 803 are finally covered with resin, by which functional portions of the PD platform 110, the LE platform 120 and the like are protected. As shown in Figures 24 and 25, locking portions 806 are preferably formed on both side surfaces of the resin 805. It is therefore possible to couple two optical connectors optically and mechanically by inserting the optical module 800 according to this embodiment into the mating connecting portion of another optical connector (not shown) and fixing the two connectors with the locking portions 806. Thus, the optical module 800 can be used as an attachable optical connector by forming the locking portions 806 on both side surfaces of the resin 805.

The present invention has thus been shown and described with reference to specific embodiments. However, it should be noted that the present invention is in no way limited to the details of the described arrangements but changes and modifications may be made without departing from the scope of the appended claims.

For example, in the above embodiment, the first platform and the second platform are encapsulated in resin. However, the encapsulation material is not particularly limited and another material may be adopted.

As explained above, since the optical module according to the present invention is constituted so that the first platform and the second platform are mounted on the single die pad and the respective platforms are independent from each other, the optical module can be easily handled. Further, if the second platform is first mounted on the die pad and the first platform is then mounted, the first platform will not be affected by the heat imparted when the light emitters and the like are mounted on the second platform body. Accordingly, temperature can be easily controlled at each process of the fabrication.

Furthermore, in fabricating the optical module of this invention, if the first platform is mounted after mounting the second platform on die pad and a screening test is then performed, it is not necessary to perform needless processing on a product in process which has an initial failure. This also helps to reduce manufacturing cost.

Moreover, since, unlike the conventional optical module, the optical module according to the present invention does not require fine tuning by a skilled worker, it has high fabrication efficiency. In addition, the optical module according to the present invention can be realized at relatively lower cost than the optical module including the conventional optical waveguide.

## Claims

1. An optical module comprising a die pad, at least two platform bodies including a first platform body and a second platform body mounted on the die pad, an optical fiber fixed on the first platform body, and a light emitter mounted on the second platform body and adapted for generating optical signals to be transmitted through the optical fiber.

2. An optical module in accordance with Claim 1, which further comprises a receiving photo-diode mounted on the first platform body and adapted for transforming optical signals received through the optical fiber into electric signals, and a filter provided so that the optical fiber is divided at the position between the receiving photo-diode and the light emitter. The optical module further comprises a ferrule in which the end portion of the optical fiber is inserted.

3. An optical module in accordance with Claim 1 or 2, which further comprises a ferrule in which the end portion of the optical fiber is inserted.

4. An optical module in accordance with any one of Claims 1 to 3, which further comprises a monitoring photo-diode which is mounted on the second platform body and used for monitoring the luminescence intensity of the light emitter.

5. An optical module in accordance with any one of Claims 1 to 4, which further comprises an encapsulation member which covers at least part of the first platform body and the second platform body and part of the die pad.

6. An optical module in accordance with Claim 5, wherein the first platform body and the second platform body are arranged on the die pad in parallel with each other.

7. An optical module in accordance with Claim 5, wherein the first platform body is placed on the second platform body.

8. An optical module in accordance with any one of Claims 1 to 7, which further comprises silicone gel which covers at least part of the optical fiber, the receiving photo-diode, the light emitter or the filter.

9. An optical module in accordance with any one of Claims 1 to 8, which further comprises at least one IC which receive the output signals from the receiving photo-diode and process the output signals and/or drive the light emitter.

10. An optical module in accordance with Claim 9, wherein the at least one IC may be mounted on the first platform body or the second platform body.

11. An optical module in accordance with Claim 9, wherein the at least one IC may be mounted on the die pad.

12. An optical module in accordance with any one of Claims 1 to 11, which further comprises a plurality of leads at least a part of which is covered by the encapsulation member.

13. An optical module in accordance with Claim 12, wherein the plurality of leads are drawn out from a package body consisting of the encapsulation member.

14. An optical module in accordance with Claim 12, wherein the plurality of leads terminated at a mounting surface consisting of the encapsulation member.

15. An optical module in accordance with any one of Claims 1 to 14, wherein the die pad is located at a side opposite to a mounting surface of the package body with respect to the platform bodies.

16. An optical module in accordance with any one of Claims 1 to 14, wherein the die pad is provided on a printed circuit board.

17. A method for fabricating an optical module for transmitting and receiving optical signals comprising a step of mounting on a die pad a second platform body including at least a light emitter which generates optical signals to be transmitted, a step of mounting on the die pad or the second platform body a first platform body including at least optical fibers, a receiving photo-diode that performs photoelectric conversion of an optical signal received through the optical fibers and a filter that separates the optical signal received from the optical signal to be transmitted, and a step of encapsulating the second platform body and the first platform body with an encapsulation member so that end portions of the optical fibers opposite to the light emitter are exposed.

18. A method for fabricating an optical module in accordance with Claim 18, which further comprises a step of mounting the second platform body on the die pad, a step of performing a screening test and mounting the first platform body on the die pad.

19. A method for fabricating an optical module in accordance with Claim 18 or 19, which further comprises a step of applying silicon gel to cover at least part of the optical fiber, the receiving photo-diode, the light emitter or the filter.
